# EUROPEAN PATENT SPECIFICATION

(11) **EP 3 955 718 B1**
(45) Date of publication and mention of the grant of the patent: **07.08.2024**
(21) Application number: 19924075.5
(22) Date of filing: 11.04.2019
(51) Int. Cl.: H05K 13/04

(54) **COMPONENT MOUNTING DEVICE AND COMPONENT MOUNTING METHOD**
KOMPONENTENMONTAGEVORRICHTUNG UND KOMPONENTENMONTAGEVERFAHREN
DISPOSITIF DE MONTAGE DE COMPOSANT ET PROCÉDÉ DE MONTAGE DE COMPOSANT

(43) Date of publication of application: 16.02.2022
(73) Proprietor: Fuji Corporation, Chiryu-shi, Aichi 472-8686 (JP)
(72) Inventor: KAWAGUCHI Koji, Chiryu-shi, Aichi 472-8686 (JP)
(74) Representative: Grünecker Patent- und Rechtsanwälte PartG mbB
(86) International application number: PCT/JP2019/015871
(87) International publication number: WO 2020/208797

(56) References cited:
- EP-A1- 3 307 041
- WO-A1-2017/029704
- WO-A1-2018/142468
- JP-A- 2002 151 893
- JP-A- 2012 151 239
- JP-A- 2016 134 531

## Description

### Technical Field

The present specification describes a technique related to a component mounting device and a component mounting method.

### Background Art

In the component conveyance device disclosed in Patent Literature 1, a pickup member for picking up a component is supported so as to be lifted and lowered in a movable head unit. A tip portion of the pickup member is provided so as to be swingable by a predetermined amount in a direction in which the pickup member protrudes and retracts with respect to a main body portion of the pickup member, and is biased in a protruding state by an elastic member.

In addition, the component conveyance device includes a detection means and a nozzle abnormality determination means. The detection means detects a position of the tip portion of the pickup member with respect to the main body portion of the pickup member. The nozzle abnormality determination means detects, based on the detection by the detection means, whether the position of the tip portion of the pickup member is within a normal range set in advance, and determines that there is an abnormality when the position of the tip portion of the pickup member is not within the normal range. As a result, the component conveyance device disclosed in Patent Literature 1 discriminates an abnormality caused by, for example, decrease in a buffing function of the tip portion of the pickup member. Patent Literature 2 measures the distance between a reference mark on a nozzle holder to a lower end of a nozzle during a pickup or mounting operation on an image taken by a side camera to detect whether a sliding movement of the nozzle relative to the nozzle holder is impeded. Patent Literature 3 and Patent Literature 4 disclose nozzle holders with a slidable nozzle biased downwards by a spring especially designed to handle components requiring a low mounting load.

### Patent Literature

Patent Literature 1: JP-A-2006-114534
Patent Literature 2: EP 3 307 041 A1
Patent Literature 3: JP 2012 151239 A
Patent Literature 4: JP 2002 151893 A

### Summary of the Invention

### Technical Problem

However, the detection means disclosed in Patent Literature 1 detects the position of the tip portion of the pickup member with respect to the main body portion of the pickup member. In view of such circumstances, the present specification describes a component mounting device and a component mounting method capable of more preferably detecting an abnormality of a component holding member by a technique different from the related art.

### Solution to Problem

The present specification discloses a component mounting device including a head main body, a shaft, a sleeve, a component holding section, a first elastic member, a second elastic member, a detecting section, and a controller. The shaft is provided on the head main body so as to be lifted and lowered. The sleeve is provided so as to be movable relative to the shaft in a vertical direction. The component holding section is provided so as to be movable relative to the sleeve in the vertical direction. The first elastic member biases the sleeve positioned at a lower end of the shaft toward a lower side in the vertical direction. The second elastic member biases the component holding section positioned at the lower end of the sleeve toward the lower side. The biasing force of the second elastic member is smaller than the biasing force of the first elastic member. The detecting section detects whether the sleeve has moved relative to the shaft when a component held by the component holding section is mounted to the board by lifting and lowering the shaft. The controller is configured to determine an abnormal state of movement resistance in case of a relative movement between the sleeve and the shaft against the biasing force of the first elastic member when the component is mounted on the board.

In addition, the present specification discloses a component mounting method using a component mounting device including a head main body, a shaft, a sleeve, a component holding section, a first elastic member, and a second elastic member, in which the component mounting method includes a detecting step and a determining step. The shaft is provided on the head main body so as to be lifted and lowered. The sleeve is provided so as to be movable relative to the shaft in a vertical direction.

The component holding section is provided so as to be movable relative to the sleeve in the vertical direction. The first elastic member biases the sleeve positioned at a lower end of the shaft toward a lower side in the vertical direction. The second elastic member biases the component holding section positioned at the lower end of the sleeve toward the lower side. The biasing force of the second elastic member is smaller than the biasing force of the first elastic member. The detecting step detects whether the sleeve has moved relative to the shaft when a component held by the component holding section is mounted to the board by lifting and lowering the shaft. The determining step determines an abnormal state of movement resistance in case of a relative movement between the sleeve and the shaft against the biasing force of the first elastic member when the component is mounted on the board.

### Advantageous Effect of the Invention

With the component mounting device described above, the component mounting device including the head main body, the shaft, the sleeve, the component holding section, the first elastic member, and the second elastic member includes the detecting section. As a result, the component mounting device can detect whether the sleeve has moved relative to the shaft when mounting the component to the board, so that it is possible to preferably detect an abnormality of the component holding member. Specifically, in a case where a movement resistance between the component holding section and the sleeve is small in a normal state of the component holding member, the sleeve does not move relative to the shaft against a biasing force of the first elastic member. On the other hand, in a case where the component holding member is in an abnormal state and the movement resistance between the component holding section and the sleeve increases, the sleeve moves relative to the shaft against the biasing force of the first elastic member. Accordingly, the detecting section can preferably detect an abnormality of the component holding member by detecting that the sleeve has moved relative to the shaft. The above description of the component mounting device can be similarly applied to the component mounting method.

### Brief Description of Drawings

Fig. 1 is a plan view showing a configuration example of component mounting device 10.
Fig. 2 is a side view showing a configuration example of mounting head 20 and head camera unit 40a.
Fig. 3 is an enlarged view showing a configuration example of tool shaft 24.
Fig. 4 is a schematic view showing an example of an attachment state when sleeve 30a is attached to shaft 24a.
Fig. 5 is a cross-sectional view showing an example of a positional relationship between sleeve 30a and shaft 24a when a movement resistance is in a normal state.
Fig. 6 is a view showing an example of a time-dependent change of positions of sleeve 30a and shaft 24a in a vertical direction (a Z-axis direction) when a movement resistance is in a normal state.
Fig. 7 is a cross-sectional view showing an example of a positional relationship between sleeve 30a and shaft 24a when a movement resistance is in an abnormal state.
Fig. 8 is a view showing an example of a time-dependent change of positions of sleeve 30a and shaft 24a in a vertical direction (a Z-axis direction) when a movement resistance is in an abnormal state.
Fig. 9 is a view showing an example of downward view image data acquired by imaging of part camera 14.
Fig. 10 is a view showing an example of side view image data PD1 acquired by imaging of head camera unit 40a.

### Description of Embodiments

### 1. Embodiment

### 1-1. Configuration example of component mounting device 10

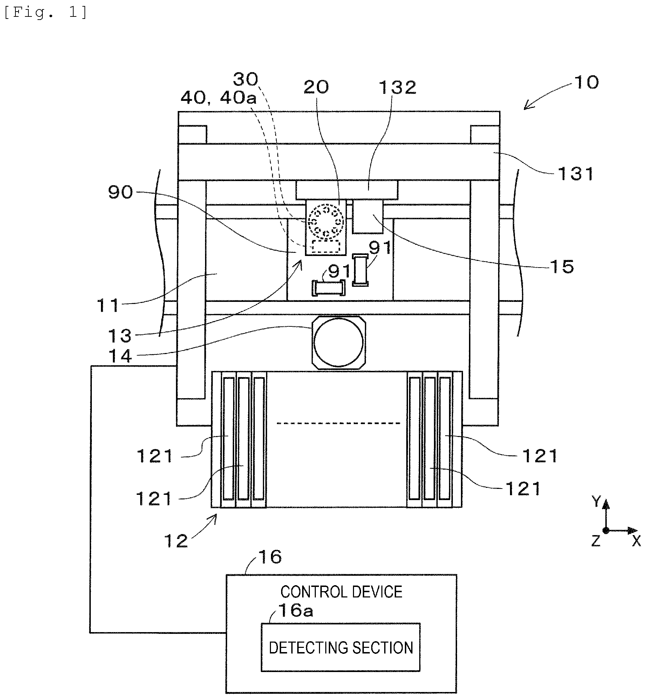

Component mounting device 10 mounts multiple components 91 on board 90. As shown in Fig. 1, component mounting device 10 includes board conveyance device 11, component supply device 12, component transfer device 13, part camera 14, board camera 15, and control device 16.

Board conveyance device 11 is configured by, for example, a belt conveyor or the like, and conveys board 90 in a conveyance direction (X-axis direction). Board 90 is a circuit board and at least one of an electronic circuit and an electrical circuit is formed. Board conveyance device 11 conveys board 90 into component mounting device 10 and positions board 90 at a predetermined position in component mounting device 10. After a mounting process of multiple components 91 by component mounting device 10 is ended, board conveyance device 11 conveys board 90 out of component mounting device 10.

Component supply device 12 supplies multiple components 91 to be mounted on board 90. Component supply device 12 includes multiple feeders 121 that are provided along the conveyance direction of board 90 (X-axis direction). Each of multiple feeders 121 pitch-feeds a carrier tape (not shown) that stores multiple components 91 to supply component 91, so that component 91 are supplied at a supply position positioned on a distal end side of feeder 121 so as to be able to pick up. In addition, component supply device 12 can supply relatively large electronic components (for example, lead components) as compared with chip components or the like, in a state of being disposed on a tray.

Component transfer device 13 includes head driving device 131 and moving body 132. Head driving device 131 is configured to move moving body 132 in the X-axis direction and the Y-axis direction by a linear motion mechanism. Mounting head 20 is detachably (exchangeably) provided to moving body 132 by a clamp member (not shown). Component mounting head 20 uses at least one component holding member 30 to pick up and hold component 91 supplied by component supply device 12, and mounts component 91 on board 90 positioned by board conveyance device 11. Component holding member 30, for example, a suction nozzle, a chuck, or the like can be used.

As part camera 14 and board camera 15, a well-known imaging device can be used. Part camera 14 is fixed to a base of component mounting device 10 such that an optical axis faces upward in the vertical direction (Z-axis direction). Part camera 14 can capture an image of component 91 held by component holding member 30 from below. Board camera 15 is provided on moving body 132 of component transfer device 13 such that the optical axis faces downward in the vertical direction (the Z-axis direction). Board camera 15 can capture an image of board 90 from above. Part camera 14 and board camera 15 perform imaging based on control signals transmitted from control device 16. Image data captured by part camera 14 and board camera 15 is transmitted to control device 16.

Control device 16 includes well-known computing device and storage device, and a control circuit is provided therein (both of which are not shown). Information, image data, and the like output from various sensors provided in component mounting device 10 are input to control device 16. Control device 16 transmits the control signals to each device based on a control program, a predetermined mounting condition which is set in advance, and the like.

For example, control device 16 causes board camera 15 to capture an image of board 90 that is positioned by board conveyance device 11. Control device 16 performs image processing with respect to the image captured by board camera 15 to recognize a positioning state of board 90. In addition, control device 16 causes component holding member 30 to pick up and hold component 91 supplied by component supply device 12, and causes part camera 14 to image component 91 held by component holding member 30. Control device 16 performs image processing with respect to the image captured by part camera 14 to recognize a holding posture of component 91.

Control device 16 moves component holding member 30 toward an upper side from a scheduled mounting position which is set in advance by the control program or the like. In addition, control device 16 corrects the mounting planned position based on the positioning state of board 90, the holding posture of component 91, and the like, and sets a mounting position on which component 91 is actually mounted. The scheduled mounting position and mounting position include a rotation angle in addition to the position (X-axis coordinate and Y-axis coordinate).

Control device 16 corrects a target position (X-axis coordinate and Y-axis coordinate) of component holding member 30 and the rotation angle in accordance with the mounting position. Control device 16 lowers component holding member 30 at the corrected rotation angle in the corrected target position, so that component 91 is mounted to board 90. Control device 16 repeats the pick- and-place cycle described above to execute the mounting process of mounting multiple components 91 on board 90.

### 1-2. Configuration example of mounting head 20

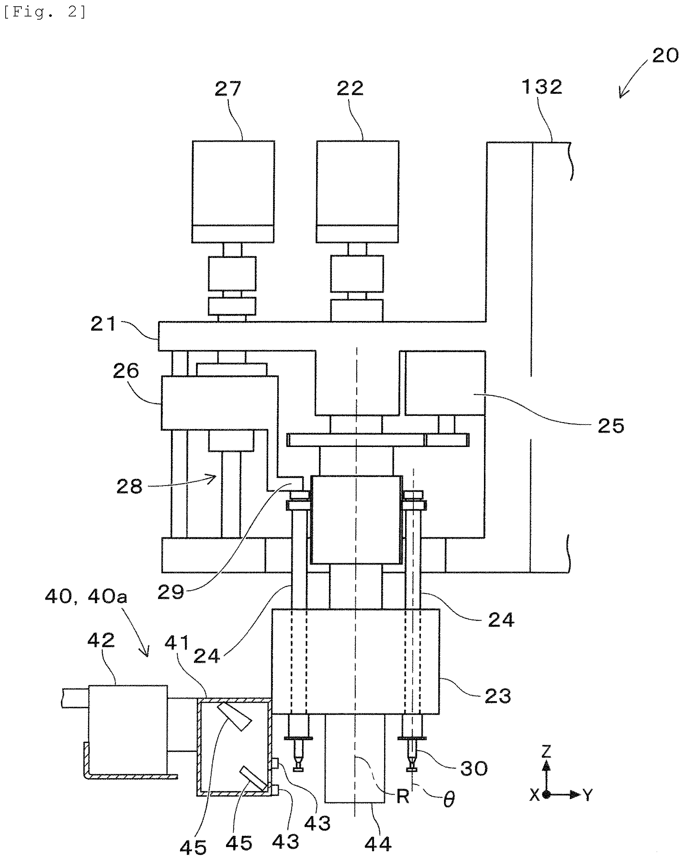

As shown in Fig. 2, mounting head 20 includes head main body 21 clamped by moving body 132. Head main body 21 is provided with rotary head 23 such that a rotation angle can be indexed for each predetermined angle by R-axis motor 22. Rotary head 23 includes multiple tool shafts 24 (for example, twelve) at equal intervals in the circumferential direction on a circumference concentric with the R-axis. Rotary head 23 holds tool shaft 24 slidably in a θ-axis direction (the vertical direction in Fig. 2) parallel to the Z-axis and the R-axis and rotatably around the θ-axis.

Tool shaft 24 is biased upward with respect to rotary head 23 by an elastic force of a spring (not shown). As a result, tool shaft 24 is positioned at a lifting end in an ordinary state where no external force is applied. Component holding member 30 is detachably attached to a lower end portion of tool shaft 24. At least positive pressure air or negative pressure air is supplied to component holding member 30 to pick up component 91. In addition, when component holding member 30 is attached, tool shaft 24 biases component holding member 30 downward by the elastic force of the elastic member described later.

Each of multiple component holding members 30 holds component 91 by supplying air to an air passage of component holding member 30. Multiple component holding members 30 are sequentially indexed to predetermined angle positions around the R-axis (for example, lifting and lowering positions of tool shaft 24) by the rotation of rotary head 23 in accordance with the driving of R-axis motor 22.

As shown in Fig. 2, mounting head 20 includes θ-axis motor 25 fixed to head main body 21. All tool shafts 24 are connected to an output shaft of θ-axis motor 25 such that rotational force can be transmitted via multiple gears. Tool shaft 24 and component holding member 30 are rotated (rotated on its axis) integrally around the θ-axis by the operation of θ-axis motor 25, so that the rotation angle and the rotation speed are controlled.

In addition, head main body 21 is provided with actuating member 26 so as to be movable in the vertical direction (the Z-axis direction). Actuating member 26 is lifted and lowered in the vertical direction (the Z-axis direction) by ball screw mechanism 28 operated by driving of Z-axis motor 27. Actuating member 26 includes lever 29 that can contact an upper end portion of tool shaft 24 that is indexed to the lifting and lowering position among multiple tool shafts 24.

Lever 29 lowers in accordance with the downward movement of actuating member 26 in the vertical direction (the Z-axis direction). Lever 29 pushes tool shaft 24 downward in the vertical direction (the Z-axis direction) against the elastic force of the spring of tool shaft 24 in contact with lever 29, and causes tool shaft 24 to lower. Tool shaft 24 and component holding member 30 are integrally lifted and lowered in the vertical direction (the Z-axis direction) by the driving of Z-axis motor 27, so that the position and the movement speed in the vertical direction (the Z-axis direction) are controlled.

### 1-3. Configuration example of tool shaft 24 and component holding member 30

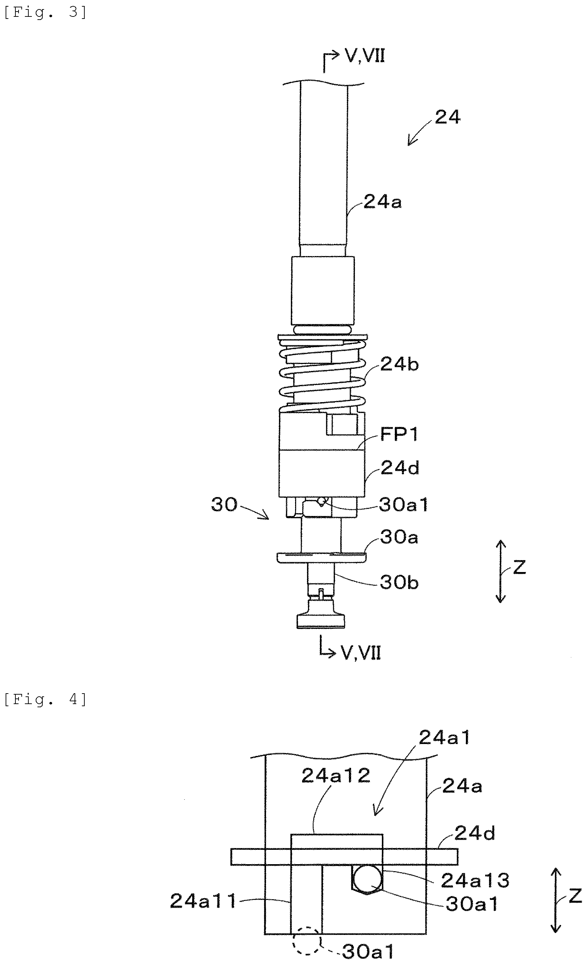

As shown in Fig. 3 to Fig. 5, tool shaft 24 of the present embodiment includes shaft 24a, first elastic member 24b, second elastic member 24c, and first member 24d. In addition, component holding member 30 includes sleeve 30a and component holding section 30b.

As described above, shaft 24a is provided on head main body 21 so as to be lifted and lowered. In addition, sleeve 30a is provided so as to be movable relative to shaft 24a in the vertical direction (the Z-axis direction). Further, first elastic member 24b biases sleeve 30a positioned at the lower end of shaft 24a toward the lower side in the vertical direction (the Z-axis direction).

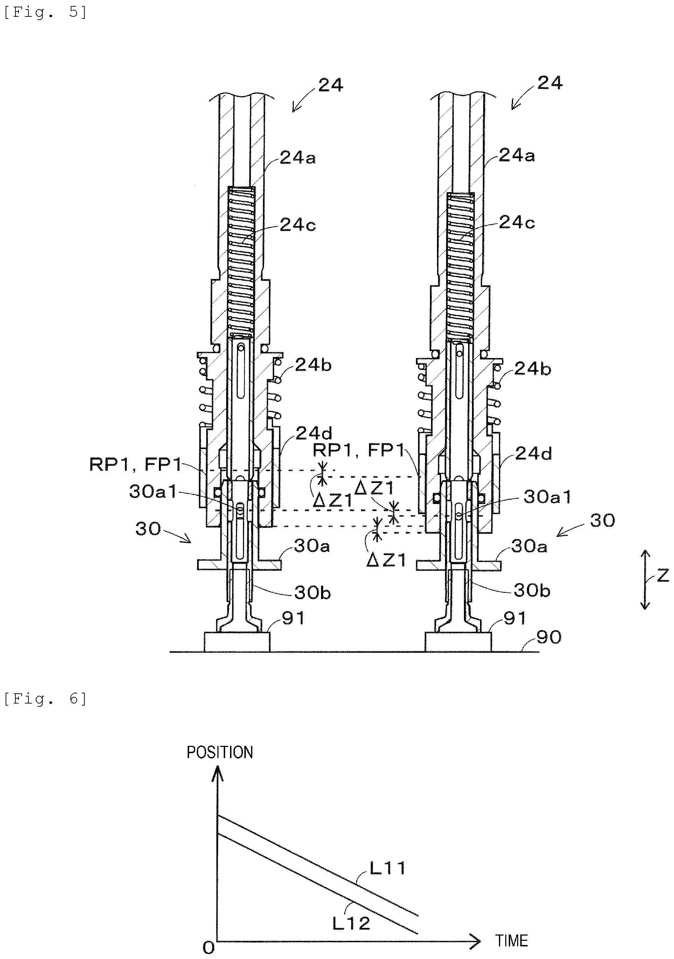

Specifically, as shown in Fig. 3 and Fig. 5, sleeve 30a provided inside shaft 24a includes protruding portion 30a1 protruding outwardly through shaft 24a. As shown in Fig. 4, guide section 24a1 capable of guiding protruding portion 30a1 when sleeve 30a is attached to shaft 24a is formed on shaft 24a.

Guide section 24a1 is formed in a groove shape and includes first groove section 24a11, second groove section 24a12, and third groove section 24a13. First groove section 24a11 is formed so as to extend from the lower end of shaft 24a toward the upper side in a vertical direction (the Z-axis direction). Second groove section 24a12 is formed so as to extend in a horizontal direction from an end portion of first groove section 24a11 on the side opposite to the lower end of shaft 24a. Third groove section 24a13 is formed so as to extend from an end portion of second groove section 24a12 on the side opposite to first groove section 24a11 toward the lower side in the vertical direction (the Z-axis direction).

A cross-sectional area of guide section 24a1 obtained by cutting guide section 24a1 in a plane perpendicular to the guide direction of protruding portion 30a1 is formed to be slightly larger than a cross-sectional area of protruding portion 30a1. Accordingly, when sleeve 30a is attached to shaft 24a, protruding portion 30a1 indicated by dashed lines in Fig. 4 can enter guide section 24a1 from the lower end of shaft 24a and move to the end point of guide section 24a1 (the end of third groove section 24a13).

First member 24d provided outside shaft 24a is a pressing member that presses protruding portion 30a1. In addition, first elastic member 24b of the present embodiment biases sleeve 30a toward the lower side via first member 24d. Accordingly, first member 24d is integrally movable with sleeve 30a. In addition, sleeve 30a is movable relative to shaft 24a in the vertical direction (the Z-axis direction).

Component holding section 30b is provided so as to be movable relative to sleeve 30a in the vertical direction (the Z-axis direction). Specifically, component holding section 30b is provided inside sleeve 30a. In addition, second elastic member 24c biases component holding section 30b positioned at the lower end of sleeve 30a toward the lower side. Accordingly, component holding section 30b is movable relative to sleeve 30a in the vertical direction (the Z-axis direction). As shown in Fig. 5, second elastic member 24c of the present embodiment biases component holding section 30b via the connection member, and second elastic member 24c is provided above first elastic member 24b in the vertical direction (the Z-axis direction). In addition, second elastic member 24c of the present embodiment biases component holding section 30b toward the lower side with a smaller biasing force than first elastic member 24b.

### 1-4. Configuration example of detecting section 16a

Foreign matter (for example, dust) may mix between component holding section 30b and sleeve 30a. When foreign matter enters, the movement resistance between component holding section 30b and sleeve 30a increases, so that the relative movement between component holding section 30b and sleeve 30a is made difficult. As a result, when component 91 held by component holding section 30b is mounted to board 90, a load applied to component 91 may increase as compared with before the movement resistance increases. Accordingly, component mounting device 10 of the present embodiment includes detecting section 16a. In addition, the biasing force of first elastic member 24b is set such that first elastic member 24b elastically deforms under a predetermined condition.

As shown in Fig. 1, control device 16 of component mounting device 10 includes detecting section 16a when viewed as a control block. Detecting section 16a detects whether sleeve 30a has moved relative to shaft 24a when component 91 held by component holding section 30b is mounted to board 90 by lifting and lowering shaft 24a.

In addition, in the present specification, a state in which the movement resistance between component holding section 30b and sleeve 30a is equal to or less than a predetermined value is referred to as a normal state. A state in which the movement resistance between component holding section 30b and sleeve 30a exceeds a predetermined value is referred to as an abnormal state. The predetermined value of the movement resistance indicates an allowable value of the load applied to component 91, and can be derived at the time of designing first elastic member 24b by simulation, verification by an actual device, or the like.

The biasing force of first elastic member 24b is preferably set such that first elastic member 24b elastically deforms when the movement resistance is in an abnormal state and shaft 24a lowers further after component 91 reaches board 90 in the mounting operation of mounting component 91 to board 90.

Fig. 5 shows an example of a positional relationship between sleeve 30a and shaft 24a when the movement resistance is in a normal state. Fig. 5 is a cross-sectional view obtained by cutting tool shaft 24 taken along the axial line direction. Tool shaft 24 on the left side in Fig. 5 shows a state in which component 91 reaches board 90 in the mounting operation. Tool shaft 24 on the right side in Fig. 5 shows a state when shaft 24a lowers further from the state of tool shaft 24 on the left side.

In a case where shaft 24a lowers further after the component 91 reaches board 90 in the mounting operation when the movement resistance is in a normal state, component holding section 30b moves relative to sleeve 30a against the biasing force of second elastic member 24c. As a result, the load applied to component 91 is reduced in comparison with a case where component holding section 30b does not move relative to sleeve 30a. At this time, biasing force of first elastic member 24b is the same as that of tool shaft 24 on the left side in Fig. 5, and first elastic member 24b is not elastically deformed. Accordingly, the positional relationship between protruding portion 30a1 of sleeve 30a and shaft 24a is maintained. That is, sleeve 30a can lower integrally with shaft 24a.

At this time, detecting section 16a detects that sleeve 30a has not moved relative to shaft 24a. The position of protruding portion 30a1 of tool shaft 24 on the right side in Fig. 5 lowers by deviation ΔZ1 in the vertical direction (the Z-axis direction) as compared with tool shaft 24 on the left side. In addition, the position of the lower end of shaft 24a of tool shaft 24 on the right side in Fig. 5 lowers by deviation ΔZ1 in the vertical direction (the Z-axis direction) as compared with tool shaft 24 on the left side.

Fig. 6 shows an example of the time-dependent change in the positions of sleeve 30a and shaft 24a in the vertical direction (the Z-axis direction) when the movement resistance is in a normal state. A horizontal axis in Fig. 6 represents time, and a vertical axis represents the position (height) in the vertical direction (the Z-axis direction). Straight line L11 represents the position (height) in the vertical direction (the Z-axis direction) of protruding portion 30a1 when the movement resistance is in a normal state. Straight line L12 represents the position (height) in the vertical direction (the Z-axis direction) of the lower end of shaft 24a when the movement resistance is in a normal state. As represented by straight lines L11 and L12, when the movement resistance is in a normal state, a difference in the positions (heights) in the vertical direction (the Z-axis direction) of sleeve 30a (protruding portion 30a1) and shaft 24a is constant. That is, Fig. 2 shows that the movement resistance is in a normal state and sleeve 30a did not move relative to shaft 24a.

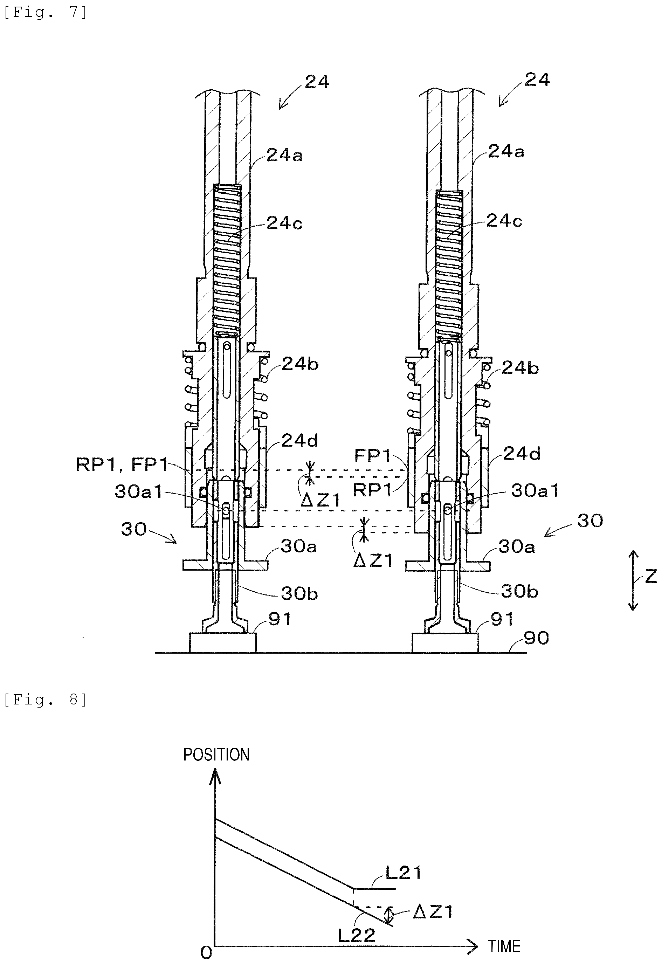

Fig. 7 shows an example of the positional relationship between sleeve 30a and shaft 24a when the movement resistance is in an abnormal state. Fig. 5 is a cross-sectional view obtained by cutting tool shaft 24 taken along the axial line direction. Tool shaft 24 on the left side in Fig. 5 shows a state in which component 91 reaches board 90 in the mounting operation. Tool shaft 24 on the right side in Fig. 5 shows a state when shaft 24a lowers further from the state of tool shaft 24 on the left side.

In a case where shaft 24a lowers further after component 91 reaches board 90 in the mounting operation when the movement resistance is in an abnormal state, component holding section 30b and sleeve 30a are stopped. The biasing force of first elastic member 24b at this time is set such that first elastic member 24b elastically deforms. Accordingly, sleeve 30a moves relative to shaft 24a against the biasing force of first elastic member 24b. As a result, the load applied to component 91 is reduced even when the movement resistance is in an abnormal state. Specifically, protruding portion 30a1 of sleeve 30a and first member 24d that presses protruding portion 30a1 relatively move upward in the vertical direction (the Z-axis direction) with respect to shaft 24a.

At this time, detecting section 16a detects that sleeve 30a has moved relative to shaft 24a against the biasing force of first elastic member 24b. The position of protruding portion 30a1 of tool shaft 24 on the right side in Fig. 7 is the same as that of tool shaft 24 on the left side, but the position of the lower end of shaft 24a of tool shaft 24 on the right side in Fig. 7 lowers by deviation ΔZ1 in the vertical direction (the Z-axis direction) as compared with tool shaft 24 on the left side.

Fig. 8 shows an example of the time-dependent change in the positions of sleeve 30a and shaft 24a in the vertical direction (the Z-axis direction) when the movement resistance is in an abnormal state. A horizontal axis in Fig. 6 represents time, and a vertical axis represents the position (height) in the vertical direction (the Z-axis direction). Polygonal line L21 represents the position (height) in the vertical direction (the Z-axis direction) of protruding portion 30a1 when the movement resistance is in an abnormal state. Straight line L22 represents the position (height) in the vertical direction (the Z-axis direction) of the lower end of shaft 24a when the movement resistance is in an abnormal state. As represented by polygonal line L21 and straight line L22, when the movement resistance is in an abnormal state, a difference in the positions (heights) in the vertical direction (the Z-axis direction) of sleeve 30a (protruding portion 30a1) and shaft 24a gradually increases from the middle. That is, Fig. 8 shows that the movement resistance is in an abnormal state, and sleeve 30a has moved relative to shaft 24a.

As described above, detecting section 16a detects whether sleeve 30a has moved relative to shaft 24a when component 91 held by component holding section 30b is mounted to board 90 by lifting and lowering shaft 24a. Component mounting device 10 can acquire the normal state of the movement resistance (the normal state of component holding member 30) when detecting section 16a detects that sleeve 30a has not moved relative to shaft 24a. In addition, component mounting device 10 can acquire the abnormal state of the movement resistance (abnormal state of component holding member 30) when detecting section 16a detects that sleeve 30a has moved relative to shaft 24a. In the latter case, component mounting device 10 can instruct the user to maintain component holding member 30.

### 1-5. Example of detection of relative movement by detecting section 16a

Component mounting device 10 preferably further includes feature section FP1 and imaging device 40. At this time, detecting section 16a preferably detects whether sleeve 30a has moved relative to shaft 24a based on the captured image of feature section FP1 captured by imaging device 40.

Feature section FP1 is provided on at least one of first member 24d, sleeve 30a, and shaft 24a that is integrally movable with sleeve 30a. Feature section FP1 may have various forms as long as detecting section 16a can detect whether sleeve 30a has moved relative to shaft 24a. Feature section FP1 is preferably a figure, a character, a symbol, a three-dimensional shape or a color, or a combination thereof.

For example, in a case where a figure (for example, a straight line or the like) is appended to an outer peripheral portion of first member 24d, feature section FP1 may include the figure. In addition, for example, in a case where a name of a manufacturer, a type of a product, a lot number, a figure such as a reference conformance mark, a character, a symbol, or the like are appended on the outer peripheral portion of first member 24d, feature section FP1 may include these. Further, for example, in a case where a three-dimensional shape such as a recessed section or a protruding portion is formed on the outer peripheral portion of first member 24d, feature section FP1 may include these. In addition, for example, in a case where a color of a part of the outer peripheral portion of first member 24d is different from another part, feature section FP1 may include the color of the part.

Furthermore, feature section FP1 may include a combination of two or more of a figure, a character, a symbol, a three-dimensional shape, and a color (referred to as a coupling feature section in the present description). The coupling feature section may be a mere combination of two or more of a figure, a character, a symbol, a three-dimensional shape, and a color, or may be a combination thereof. For example, in a case where a name or the like of the manufacturer is stamped on the outer peripheral portion of first member 24d, the stamping may be the coupling feature section in which a figure, a character, or a symbol is coupled to a three-dimensional shape.

### 1-6. Configuration example of head camera unit 40a

Imaging device 40 is fixed to head main body 21 and captures an image of feature section FP1. Imaging device 40 is preferably head camera unit 40a that captures an image of component 91 held by component holding section 30b from a lateral side.

Fig. 2 shows a configuration example of head camera unit 40a, and schematically shows an inner portion of head camera unit 40a. As shown in Fig. 2, head camera unit 40a is provided on mounting head 20, and integrally moves with mounting head 20 in accordance with the movement of moving body 132. Head camera unit 40a uses component holding member 30 attached to tool shaft 24, component 91 held by component holding member 30, and feature section FP1 as a subject. Head camera unit 40a irradiates the subject with light based on an imaging command by control device 16 of component mounting device 10 to image the subject from the lateral side.

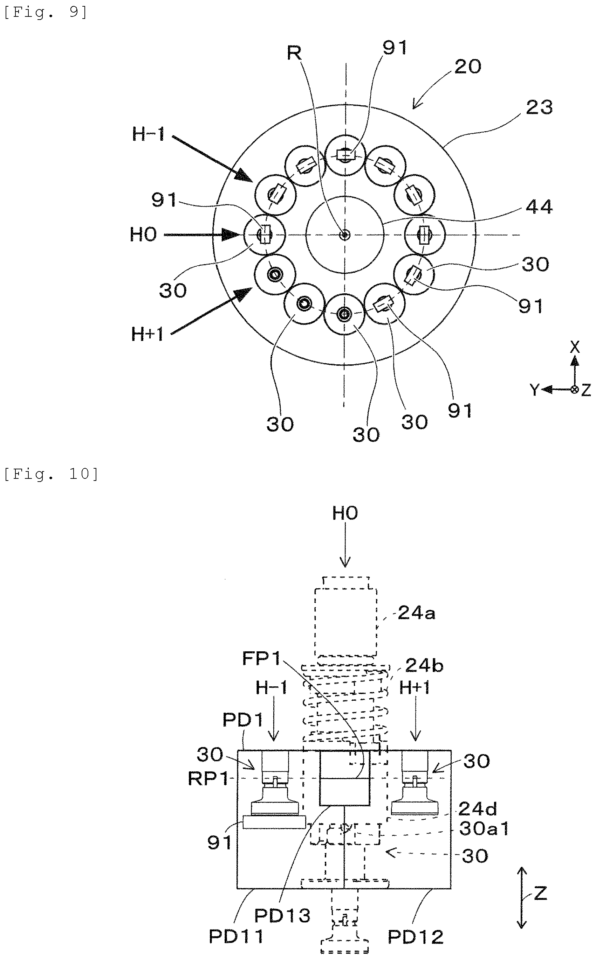

Here, as shown in Fig. 9, positions of two component holding members 30 adjacent to component holding member 30 positioned in lifting and lowering position H0 lifted and lowered by mounting head 20 are defined as front standby position H-1 and rear standby position H+1. Front standby position H-1 is a position at which component holding member 30 to be indexed next time to lifting and lowering position H0 by the rotation of rotary head 23 is placed in standby. Rear standby position H+1 is a position at which component holding member 30 previously indexed to lifting and lowering position H0 by the rotation of rotary head 23 is placed in standby.

As shown in Fig. 2, head camera unit 40a includes case 41, camera device 42, light source 43, reflection member 44, and optical member 45. Case 41 is provided so as to surround a part of multiple component holding members 30 disposed on the circumference of rotary head 23 from the outer peripheral side. Camera device 42 is provided on moving body 132 via mounting head 20. Camera device 42 captures images of two component holding members 30 positioned at front standby position H-1 and rear standby position H+1, and an image of component 91 held by component holding member 30 positioned at front standby position H-1. In addition, camera device 42 captures the image of feature section FP1 of tool shaft 24 including component holding member 30 indexed to lifting and lowering position H0.

Light source 43 is disposed on a cylindrical inner peripheral surface of case 41 facing component holding member 30 and feature section FP1. Light source 43 performs irradiation of ultraviolet light in a center direction of rotary head 23 (direction toward the R-axis). Reflection member 44 is formed in a cylindrical shape and is disposed coaxially with the R-axis at a lower end of rotary head 23. Reflection member 44 reflects the ultraviolet light irradiated from light source 43 on the cylindrical outer peripheral surface to make visible light. In addition, light source 43 irradiates feature section FP1 with visible light without passing through reflection member 44.

Optical member 45 is disposed inside case 41 to form a light path from a subject to camera device 42. Specifically, optical member 45 forms the light path such that two component holding members 30 irradiated with the reflected light reflected by reflection member 44 are contained in the camera visual field of camera device 42. In addition, optical member 45 forms the light path such that feature section FP1 of tool shaft 24 including component holding member 30 indexed to lifting and lowering position H0 is contained in the camera visual field described above.

Therefore, in rotary head 23, optical member 45 forms the light path such that the tip portion of two component holding members 30 indexed to front standby position H-1 and rear standby position H+1 and feature section FP1 of tool shaft 24 having component holding member 30 indexed to lifting and lowering position H0 are contained in the same camera visual field. As a result, head camera unit 40a can capture the images of component holding member 30, component 91, and feature section FP1 in the same camera visual field. Side view image data PD1 captured by camera device 42 is transmitted to control device 16.

Side view image data PD1 shown in Fig. 10 is defined into first region PD11, second region PD12, and third region PD13. First region PD11 is a region where the image of the tip portion of component holding member 30 indexed to front standby position H-1 is captured. Second region PD12 is a region where the image of the tip portion of component holding member 30 indexed to rear standby position H+1 is captured. Third region PD13 is a region where the image of feature section FP1 of tool shaft 24 is captured when component holding member 30 indexed to lifting and lowering position H0 is lowered in the mounting process.

In addition, the images of component holding member 30 and component 91 are simultaneously captured. Side view image data PD1 at this time is captured such that a region where component holding member 30 and component 91 are present is shaded with reflection member 44 as a background. In side view image data PD1, image processing such as binarization is executed in camera device 42 or control device 16, so that the contrast with the background is emphasized.

As shown in Fig. 3, feature section FP1 of the present embodiment is provided in first member 24d. Specifically, feature section FP1 is a straight line attached to the outer peripheral portion of first member 24d. As described above, sleeve 30a provided on the inner side of shaft 24a includes protruding portion 30a1 protruding outward through shaft 24a. In addition, first member 24d provided outside shaft 24a is a pressing member that presses protruding portion 30a1. Further, first elastic member 24b biases sleeve 30a toward the lower side via first member 24d.

When shaft 24a is further lowered after component 91 reaches board 90 in the mounting operation when the movement resistance is in a normal state, sleeve 30a is lowered integrally with shaft 24a. Accordingly, the straight line attached to the outer peripheral portion of first member 24d, which is feature section FP1, is lowered in accordance with the lowering of shaft 24a. At this time, head camera unit 40a continuously captures the image of feature section FP1.

Detecting section 16a can acquire a change in the position (height) in the vertical direction (the Z-axis direction) of feature section FP1 with respect to reference position RP1 of shaft 24a based on the captured image of feature section FP1 captured by head camera unit 40a. Reference position RP1 of shaft 24a is a virtual position of shaft 24a in the captured image of feature section FP1 (third region PD13 shown in Fig. 10), and is lowered in conjunction with the mounting operation. Reference position RP1 of shaft 24a of the present embodiment is a part that is lowered in conjunction with the mounting operation at the same position (height) as the position (height) in the vertical direction (Z-axis direction) of feature section FP1 when the movement resistance is in the normal state. As shown in Fig. 5, in a case where the movement resistance is in the normal state, detecting section 16a detects that sleeve 30a has not moved relative to shaft 24a since the position (height) in the vertical direction (the Z-axis direction) of feature section FP1 is the same as reference position RP1 of shaft 24a.

In a case where shaft 24a lowers further after component 91 reaches board 90 in the mounting operation when the movement resistance is in an abnormal state, component holding section 30b and sleeve 30a are stopped. Accordingly, the straight line attached to the outer peripheral portion of first member 24d, which is feature section FP1, does not lower and maintains a predetermined position (height). At this time, head camera unit 40a continuously captures an image of feature section FP1, similarly to the case where the movement resistance is in the normal state. As shown in Fig. 7, in this case, detecting section 16a detects that sleeve 30a has moved relative to shaft 24a against the biasing force of first elastic member 24b since the position (height) in the vertical direction (the Z-axis direction) of feature section FP1 differs from reference position RP1 of shaft 24a.

Shaft 24a is lifted and lowered in the vertical direction (the Z-axis direction) by the driving of Z-axis motor 27 shown in Fig. 2. Accordingly, detecting section 16a can acquire reference position RP1 of shaft 24a based on the detection result of a position detector (for example, an encoder or the like) provided in Z-axis motor 27. In addition, reference position RP1 of shaft 24a may be a position (height) that is spaced apart from feature section FP1 in the vertical direction (the Z-axis direction) by a predetermined amount when the movement resistance is in the normal state, and may be a part that is lowered in conjunction with the mounting operation. In this case, detecting section 16a detects whether sleeve 30a has moved relative to shaft 24a based on whether a distance between reference position RP1 of shaft 24a and the vertical direction (the Z-axis direction) of feature section FP1 is a predetermined amount.

Further, in a case where feature section FP1 is provided on both first member 24d and shaft 24a, reference position RP1 of shaft 24a may be the position of feature section FP1 provided on shaft 24a captured by head camera unit 40a. In this case, detecting section 16a acquires the position (height) in the vertical direction (the Z-axis direction) between feature section FP1 provided on shaft 24a indicating reference position RP1 of shaft 24a and feature section FP1 provided on first member 24d. Detecting section 16a detects, for example, that sleeve 30a has not moved relative to shaft 24a when the position (height) in the vertical direction (the Z-axis direction) of feature section FP1 provided in first member 24d is the same as feature section FP1 (reference position RP1 of shaft 24a) provided in shaft 24a. Detecting section 16a detects that sleeve 30a has moved relative to shaft 24a when the position (height) in the vertical direction (the Z-axis direction) of feature section FP1 provided in first member 24d is different from feature section FP1 (reference position RP1 of shaft 24a) provided in shaft 24a.

Feature section FP1 may also be provided in sleeve 30a. In this case, shaft 24a preferably includes a transmitting portion that transmits light. Sleeve 30a provided inside shaft 24a may extend to the transmitting portion. In addition, sleeve 30a may include an extension member extending from the main body portion to the transmitting portion of sleeve 30a. In any case, imaging device 40 can capture an image of feature section FP1 via the transmitting portion.

Feature section FP1 may also be provided on shaft 24a. In this case, when sleeve 30a has moved relative to shaft 24a, feature section FP1 is preferably provided so as to be covered by first member 24d. Detecting section 16a detects that sleeve 30a has not moved relative to shaft 24a since an image of feature section FP1 is captured in the captured image captured by imaging device 40. In addition, since the image of feature section FP1 is not captured in the captured image captured by imaging device 40, detecting section 16a detects that sleeve 30a has moved relative to shaft 24a against the biasing force of first elastic member 24b.

Light source 43 of head camera unit 40a can directly irradiate feature section FP1 with ultraviolet light. In this case, for example, feature section FP1 provided on first member 24d may be formed of the same material as reflection member 44. As a result, the ultraviolet light irradiated from light source 43 is reflected by feature section FP1 to be visible light, so that camera device 42 can capture the image of feature section FP1. In this case, the image of feature section FP1 is captured in a shadow region where first member 24d is present.

In addition, shaft 24a may include slits on both sides of reflection member 44 and camera device 42 in the light path for capturing the image of feature section FP1. In this case, when sleeve 30a does not move relative to shaft 24a, the reflected light reflected by reflection member 44 passes through the slit and reaches camera device 42, so that the reflected light may be shielded when sleeve 30a has moved relative to shaft 24a.

Further, detecting section 16a may detect whether sleeve 30a has moved relative to shaft 24a when component 91 held by component holding section 30b is mounted to board 90 by lifting and lowering shaft 24a, and may take various forms other than a form using imaging device 40. For example, a light projector may be provided on one of shaft 24a and sleeve 30a, and a light receiver may be provided on the other of shaft 24a and sleeve 30a. In this case, when sleeve 30a does not move relative to shaft 24a, the light irradiated from the light projector may reach the light receiver, and when sleeve 30a has moved relative to shaft 24a, the light irradiated from the light projector may be shielded. Alternatively, an electric contact may be used. In this case, the contact may be electrically conductive when sleeve 30a does not move relative to shaft 24a, and need not be electrically conductive when sleeve 30a has moved relative to shaft 24a.

### 2. Component mounting method

The above description of component mounting device 10 can be similarly applied to the component mounting method. Specifically, the component mounting method is a component mounting method using component mounting device 10 including head main body 21, shaft 24a, sleeve 30a, component holding section 30b, first elastic member 24b, and second elastic member 24c, and includes a detecting step and a determining step. The detecting step corresponds to the detection performed by detecting section 16a. The determining step corresponds to the control performed by the controller (16) in determining an abnormal state of movement resistance in case of the relative movement between the sleeve and the shaft. In addition, the component mounting method may also include a notifying step of notifying the user of component mounting device 10 of the detection result detected by the detecting step.

### 3. An example of effect of embodiment

With component mounting device 10, component mounting device 10 including head main body 21, shaft 24a, sleeve 30a, component holding section 30b, first elastic member24b, and second elastic member24c includes detecting section 16a. As a result, component mounting device 10 can detect whether sleeve 30a has moved relative to shaft 24a when mounting component 91 to board 90, so that it is possible to preferably detect an abnormality of component holding member 30. Specifically, in a case where a movement resistance between component holding section 30b and sleeve 30a is small in a normal state of the component holding member 30, sleeve 30a does not move relative to shaft 24a against a biasing force of first elastic member 24b. On the other hand, in a case where component holding member 30 is in an abnormal state and the movement resistance between component holding section 30b and sleeve 30a increases, sleeve 30a moves relative to shaft 24a against the biasing force of first elastic member 24b. Accordingly, detecting section 16a can preferably detect an abnormality of component holding member 30 by detecting that sleeve 30a has moved relative to shaft 24a. The above description of component mounting device 10 can be similarly applied to the component mounting method.

### Reference Signs List

10: Component mounting device, 16a: Detecting section, 21: Head main body, 24a: Shaft, 24b: First elastic member, 24c: Second elastic member, 24d: First member, 30a: Sleeve, 30a1: Protruding portion, 30b: Component holding section, 40: Imaging device, 40a: Head camera unit, 90: Board, 91: Component, FP1: Feature section, Z-axis direction: Vertical direction

## Claims

1. A component mounting device (10) comprising:
a head main body (21);
a shaft (24a) provided on the head main body (21) so as to be lifted and lowered;
a sleeve (30a) provided so as to be movable relative to the shaft (24a) in a vertical direction;
a component holding section (30b);
a first elastic member (24b) configured to bias the sleeve (30a) positioned at a lower end of the shaft (24a) toward a lower side in the vertical direction; and
a second elastic member (24c) configured to bias the component holding section (30b) positioned at a lower end of the sleeve (30a) toward the lower side,
**characterized in that**
the component holding section (30b) is provided so as to be movable relative to the sleeve (30a) in the vertical direction,
the biasing force of the second elastic member (24c) is smaller than the biasing force of the first elastic member (24b),
a detecting section (16a) is provided that is configured to detect whether the sleeve (30a) has moved relative to the shaft (24a) when a component (91) held by the component holding section (30b) is mounted on a board (90) by lifting and lowering the shaft (24a), and
a controller (16) is provided that is configured to determine an abnormal state of movement resistance in case of a relative movement between the sleeve (30a) and the shaft (24a) against the biasing force of the first elastic member (24b) when the component (91) is mounted on the board (90).

2. The component mounting device (10) according to claim 1, wherein
the detecting section (16a) detects that the sleeve (30a) moves relative to the shaft (24a) against a biasing force of the first elastic member (24b) when the shaft (24a) lowers further after the component (91) reaches the board (90) in a mounting operation of mounting the component (91) to the board (90).

3. The component mounting device (10) according to claim 1 or 2, further comprising:
a feature section (FP1) provided on at least one of a first member (24d) integrally movable with the sleeve (30a), the sleeve (30a), and the shaft (24a); and
an imaging device (40) fixed to the head main body (21) and capable of imaging the feature section (FP1), wherein
the detecting section (16a) detects whether the sleeve (30a) has moved relative to the shaft (24a) based on a captured image of the feature section (FP1) imaged by the imaging device (40).

4. The component mounting device (10) according to claim 3, wherein
the sleeve (30a) provided inside the shaft (24a) includes a protruding portion (30a1) that protrudes outward through the shaft (24a),
the first member (24d) provided outside the shaft (24a) is a pressing member that presses the protruding portion (30a1),
the feature section (FP1) is provided on the first member (24d), and
the first elastic member (24b) biases the sleeve (30a) toward the lower side via the first member (24d).

5. The component mounting device (10) according to claim 3 or 4, wherein
the imaging device (40) is a head camera unit (40a) that images the component (91) held by the component holding section (30b) from a lateral side.

6. A component mounting method using a component mounting device (10) including
a head main body (21),
a shaft (24a) provided on the head main body (21) so as to be lifted and lowered,
a sleeve (30a) provided so as to be movable relative to the shaft (24a) in a vertical direction,
a component holding section (30b) provided so as to be movable relative to the sleeve (30a) in the vertical direction,
a first elastic member (24b) configured to bias the sleeve (30a) positioned at a lower end of the shaft (24a) toward a lower side in the vertical direction, and
a second elastic member (24c) configured to bias the component holding section (30b) positioned at a lower end of the sleeve (30a) toward the lower side,
wherein the biasing force of the second elastic member (24c) is smaller than the biasing force of the first elastic member (24b),
**characterized in that**
the component mounting method comprises:
a detecting step of detecting whether the sleeve (30a) has moved relative to the shaft (24a) when a component (91) held by the component holding section (30b) is mounted on a board (90) by lifting and lowering the shaft (24a), and
a determining step of determining an abnormal state of movement resistance in case of a relative movement between the sleeve (30a) and the shaft (24a) against the biasing force of the first elastic member (24b) when the component (91) is mounted on the board (90).

## Patentansprüche

1. Komponentenmontagevorrichtung (10) umfassend:
einen Kopfhauptkörper (21);
einen Schaft (24a), der an dem Kopfhauptkörper (21) so vorgesehen ist, dass er angehoben und abgesenkt werden kann;
eine Hülse (30a), die so vorgesehen ist, dass sie relativ zu dem Schaft (24a) in einer vertikalen Richtung beweglich ist;
einen Komponentenhalteabschnitt (30b);
ein erstes elastisches Element (24b), das so konfiguriert ist, dass es die an einem unteren Ende des Schafts (24a) angeordnete Hülse (30a) zu einer unteren Seite in der vertikalen Richtung vorspannt; und
ein zweites elastisches Element (24c), das so konfiguriert ist, dass es den an einem unteren Ende der Hülse (30a) angeordneten Komponentenhalteabschnitt (30b) in Richtung der unteren Seite vorspannt,
**dadurch gekennzeichnet, dass**
der Komponentenhalteabschnitt (30b) so vorgesehen ist, dass er relativ zur Hülse (30a) in der vertikalen Richtung beweglich ist,
die Vorspannkraft des zweiten elastischen Elements (24c) kleiner ist als die Vorspannkraft des ersten elastischen Elements (24b),
ein Erfassungsabschnitt (16a) vorgesehen ist, der konfiguriert ist, um zu erfassen, ob sich die Hülse (30a) relativ zu dem Schaft (24a) bewegt hat, wenn eine von dem Komponentenhalteabschnitt (30b) gehaltene Komponente (91) durch Anheben und Absenken des Schafts (24a) auf einer Platine (90) montiert wird, und
eine Steuerung (16) vorgesehen ist, die so konfiguriert ist, dass sie einen abnormalen Zustand des Bewegungswiderstands bestimmt im Falle einer Relativbewegung zwischen der Hülse (30a) und dem Schaft (24a) gegen die Vorspannkraft des ersten elastischen Elements (24b), wenn die Komponente (91) auf der Platine (90) montiert wird.

2. Komponentenmontagevorrichtung (10) nach Anspruch 1, wobei
der Erfassungsabschnitt (16a) erfasst, dass sich die Hülse (30a) relativ zu dem Schaft (24a) gegen eine Vorspannkraft des ersten elastischen Elements (24b) bewegt, wenn sich der Schaft (24a) weiter absenkt, nachdem die Komponente (91) bei einem Montagevorgang zum Montieren der Komponente (91) an der Platine (90) die Platine (90) erreicht hat.

3. Komponentenmontagevorrichtung (10) nach Anspruch 1 oder 2, die ferner umfassend:
einen Merkmalsabschnitt (FP1), der an mindestens einem von einem ersten Element (24d), das integral mit der Hülse (30a) beweglich ist, der Hülse (30a) und dem Schaft (24a) vorgesehen ist; und
eine Bildgebungsvorrichtung (40), die an dem Kopfhauptkörper (21) befestigt ist und der in der Lage ist, den Merkmalsabschnitt (FP1) abzubilden, wobei
der Erfassungsabschnitt (16a) basierend auf einem aufgenommenen Bild des Merkmalsabschnitts (FP1), das von der Bildgebungsvorrichtung (40) abgebildet worden ist, erfasst, ob sich die Hülse (30a) relativ zum Schaft (24a) bewegt hat.

4. Komponentenmontagevorrichtung (10) nach Anspruch 3, wobei
die Hülse (30a), die innerhalb des Schafts (24a) vorgesehen ist, einen hervorstehenden Abschnitt (30a1) aufweist, der durch den Schaft (24a) nach außen vorsteht,
das erste Element (24d), das außerhalb des Schafts (24a) vorgesehen ist, ein Druckelement ist, das auf den hervorstehenden Abschnitt (30a1) drückt,
der Merkmalsabschnitt (FP1) an dem ersten Element (24d) vorgesehen ist und
das erste elastische Element (24b) die Hülse (30a) über das erste Element (24d) in Richtung der unteren Seite vorspannt.

5. Komponentenmontagevorrichtung (10) nach Anspruch 3 oder 4, wobei
die Bildgebungsvorrichtung (40) eine Kopf-Kameraeinheit (40a) ist, die die von dem Komponentenhalteabschnitt (30b) gehaltene Komponente (91) von einer Seite abbildet.

6. Komponentenmontageverfahren unter Verwendung einer Komponentenmontagevorrichtung (10), die umfasst:
einen Kopfhauptkörper (21),
einen Schaft (24a), der an dem Kopfhauptkörper (21) so vorgesehen ist, dass er angehoben und abgesenkt werden kann,
eine Hülse (30a), die so vorgesehen ist, dass sie relativ zu dem Schaft (24a) in einer vertikalen Richtung beweglich ist,
einen Komponentenhalteabschnitt (30b), der so vorgesehen ist, dass er relativ zur Hülse (30a) in der vertikalen Richtung beweglich ist,
ein erstes elastisches Element (24b), das so konfiguriert ist, dass es die an einem unteren Ende des Schafts (24a) angeordnete Hülse (30a) zu einer unteren Seite in der vertikalen Richtung vorspannt; und
ein zweites elastisches Element (24c), das so konfiguriert ist, dass es den an einem unteren Ende der Hülse (30a) angeordneten Komponentenhalteabschnitt (30b) in Richtung der unteren Seite vorspannt,
wobei die Vorspannkraft des zweiten elastischen Elements (24c) kleiner ist als die Vorspannkraft des ersten elastischen Elements (24b),
**dadurch gekennzeichnet, dass**
das Komponentenmontageverfahren umfasst:
ein Erfassungsschritt zum Erfassen, ob sich die Hülse (30a) relativ zu dem Schaft (24a) bewegt hat, wenn eine von dem Komponentenhalteabschnitt (30b) gehaltene Komponente (91) durch Anheben und Absenken des Schafts (24a) auf einer Platine (90) montiert wird, und
ein Bestimmungsschritt zum Bestimmen eines abnormalen Zustands des Bewegungswiderstands im Falle einer Relativbewegung zwischen der Hülse (30a) und dem Schaft (24a) gegen die Vorspannkraft des ersten elastischen Elements (24b), wenn die Komponente (91) auf der Platine (90) montiert wird.

## Revendications

1. Dispositif de montage de composant (10) comprenant :
un corps principal de tête (21) ;
un arbre (24a) prévu sur le corps principal de la tête (21) de manière à être soulevé et abaissé ;
un manchon (30a) prévu de manière à être mobile par rapport à l'arbre (24a) dans une direction verticale ;
une section de maintien de composant (30b) ;
un premier élément élastique (24b) configuré pour orienter le manchon (30a) positionné à une extrémité inférieure de l'arbre (24a) vers un côté inférieur dans la direction verticale ; et
un second élément élastique (24c) configuré pour polariser la section de maintien du composant (30b) positionnée à une extrémité inférieure du manchon (30a) vers le côté inférieur,
**caractérisé en ce que**
la section de maintien des composants (30b) est prévue de manière à être mobile par rapport au manchon (30a) dans le sens vertical,
la force de polarisation du second élément élastique (24c) est inférieure à la force de polarisation du premier élément élastique (24b),
une section de détection (16a) est prévue, configurée pour détecter si le manchon (30a) s'est déplacé par rapport à l'arbre (24a) lorsqu'un composant (91) maintenu par la section de maintien du composant (30b) est monté sur une planche (90) en soulevant et en abaissant l'arbre (24a), et
un dispositif de commande (16) est prévu, configuré pour déterminer un état anormal de résistance au mouvement en cas de mouvement relatif entre le manchon (30a) et l'arbre (24a) contre la force de polarisation du premier élément élastique (24b) lorsque le composant (91) est monté sur la carte (90).

2. Dispositif de montage de composant (10) selon la revendication 1, dans lequel
la section de détection (16a) détecte que le manchon (30a) se déplace par rapport à l'arbre (24a) contre une force de polarisation du premier élément élastique (24b) lorsque l'arbre (24a) s'abaisse davantage après que le composant (91) a atteint la carte (90) dans une opération de montage du composant (91) sur la carte (90).

3. Dispositif de montage de composant (10) selon les revendications 1 ou 2, comprenant en outre :
une section caractéristique (FP1) prévue sur au moins un des premiers éléments (24d) intégralement mobiles avec le manchon (30a), le manchon (30a) et l'arbre (24a) ; et
un dispositif d'imagerie (40) fixé au corps principal de la tête (21) et capable d'imager la section de caractéristiques (FP1), dans lequel
la section de détection (16a) détecte si le manchon (30a) s'est déplacé par rapport à l'arbre (24a) sur la base d'une image capturée de la section de caractéristique (FP1) imagée par le dispositif d'imagerie (40).

4. Dispositif de montage de composant (10) selon la revendication 3, dans lequel
le manchon (30a) prévu à l'intérieur de l'arbre (24a) comprend une partie saillante (30a 1) qui dépasse vers l'extérieur à travers l'arbre (24a),
le premier élément (24d) prévu à l'extérieur de l'arbre (24a) est un élément de pressage qui presse la partie saillante (30a1),
la section de caractéristique (FP1) est prévue sur le premier élément (24d), et
le premier élément élastique (24b) biaise le manchon (30a) vers le côté inférieur à l'aide du premier élément (24d).

5. Dispositif de montage de composant (10) selon les revendications 3 ou 4, dans lequel le dispositif d'imagerie (40) est une unité de caméra de tête (40a) qui prend des images du composant (91) maintenu par la section de maintien du composant (30b) d'un côté latéral.

6. Procédé de montage de composants utilisant un dispositif de montage de composants (10) comprenant
un corps principal de tête (21),
un arbre (24a) prévu sur le corps principal de la tête (21) de manière à être soulevé et abaissé,
un manchon (30a) prévu de manière à être mobile par rapport à l'arbre (24a) dans une direction verticale,
une section de maintien d'élément (30b) prévue de manière à être mobile par rapport au manchon (30a) dans le sens vertical,
un premier élément élastique (24b) configuré pour orienter le manchon (30a) positionné à une extrémité inférieure de l'arbre (24a) vers un côté inférieur dans le sens vertical, et
un second élément élastique (24c) configuré pour polariser la section de maintien du composant (30b) positionnée à une extrémité inférieure du manchon (30a) vers le côté inférieur,
dans lequel la force de polarisation du second élément élastique (24c) est inférieure à la force de polarisation du premier élément élastique (24b),
**caractérisé en ce que**
le procédé de montage d'un composant comprend :
une étape de détection consistant à détecter si le manchon (30a) s'est déplacé par rapport à l'arbre (24a) lorsqu'un composant (91) maintenu par la section de maintien du composant (30b) est monté sur une planche (90) en soulevant et en abaissant l'arbre (24a), et
une étape déterminante consistant à déterminer un état anormal de résistance au mouvement en cas de mouvement relatif entre le manchon (30a) et l'arbre (24a) contre la force de polarisation du premier élément élastique (24b) lorsque le composant (91) est monté sur la carte (90).
